# EUROPEAN PATENT APPLICATION

(11) **EP 1 935 634 A1**
(43) Date of publication of application: **25.06.2008**
(21) Application number: 06026416.5
(22) Date of filing: 20.12.2006
(51) Int. Cl.: B32B 17/10, H05B 3/84, H05K 3/20

(54) **Method for the production of a randomly patterned electrically condutive element**

(71) Applicant: Scheuten S.à.r.l., 5916 PA Venlo (NL)
(72) Inventor: Rothfusz, Paul, 5591 PG Heeze (NL)
(74) Representative: Jostarndt, Hans-Dieter

(57) **Abstract**

The present invention concerns a method for randomly patterning electrically conductive elements (6), the patterned electrically conductive elements produced thereby and their use for example as heating elements or antennas.

## Description

The present invention concerns a method for patterning electrically conductive elements, the electrically conductive elements produced thereby and their use for example as heating elements or antennas.

Electrically conductive heating elements are widely used specially for heating laminated glazing and particularly car glazing. In these cases, the electrically conductive elements are essentially used for deicing and demisting purposes.

Although various embodiments of electrically conductive heating elements are known in the art, most of them comprise parallel aligned lines and/or wires, which could be either straight or curved.

However, glare and/or appearing diffraction patterns are observed due to optical reflection and/or diffraction phenomena. The glare and/or appearing diffraction patterns is/are especially noticeable under strong lighting conditions, like for example under strong daylight or when the headlights of an oncoming vehicle shine through the heatable car glazing.

To reduce the annoyance resulting from the glare and/or from appearing diffraction patterns several solutions were already proposed in the art.

The US-Patent 3729616 teaches to use prestressed resistance wires applied under tension to a thermoplastic sheet, so that individual wires are in a closely spaced parallel relationship. Upon heating the wires and the thermoplastic sheet, the individual wires may expand to adopt a configuration attributable to the prestressed forces, while also becoming partially embedded in the softened thermoplastic sheet. That provides a randomization in the wire pattern, so that individual wires have a wrinkled or irregular crimp at irregular intervals along their length. This reduces the glare considerably.

The German patent DE 2013112 teaches that the annoyance resulting from diffraction phenomena may be reduced by placing the heating wires in parallel wave-like configurations. The annoyance resulting from diffraction phenomena may even further be reduced, if the wave-like configurations of the parallel laying heating wires vary in an irregular way. To get irregular varying wave-like configurations without special equipment, it is proposed to expand parallel disposed straight heating wires into a thermoplastic sheet using at least one roll with an irregular shape.

The German patent DE 2350427 teaches that the annoyance resulting from X-shaped diffraction patterns, which appear when punctual light sources such as the headlights of an oncoming vehicle shine through the heatable car glazing, may be reduced by applying an elastic deformation to the heating wires while placing them in a very special wave-like way on a thermoplastic sheet. Depending on the elastic modulus, the diameter and the strongest curving radius of the deposited wires even using a regular wave-like deposition pattern may lead to irregular wave-like configurations of the heating wires after a heat treatment, which melts the thermoplastic sheet, because of restoring forces previously stored in the wires upon deformation.

Although these known processes reduce the annoyance resulting from the glare and/or from appearing diffraction patterns, they fail to allow the control of the length of the wires/lines of the electrically conductive elements, which may be heating lines or heating wires, because of the indispensable randomization, which hinders two heating lines or heating wires to have the same length on purpose.

Actually, the processes described in the art lead to random wave-like configurations for each individual heating wire, without any control on the length of these heating wires. Each individual heating wire has therefore a different wave-like configuration obtained by non-controlled processes, which allow getting randomly varying amplitudes and wavelengths for each wave-like configurations of each individual heating wire over his whole length. This means that two individual heating wires with randomly varying amplitudes and wavelengths for their different wave-like configurations over their whole length may not or only by coincidence have the same length.

This limitation is inherent to the processes used to achieve randomization.

Neither by expanding the wires into a thermoplastic material with a roll having an irregular shape, nor by letting prestressed and/or deformed wires adopt a configuration attributable to restoring forces within a sheet of a thermoplastic material, one has the possibility to control and/or to select the length of the heating wires, simply because the processes are random and not controlled in any way, as the object is to get a complete randomization of the wave-like configuration of the heating wires.

Controlling the length of the heating wires and/or heating lines may however allow either to get an homogeneous heating at least in a certain area, when the same length is selected for of all the heating wires and/or heating lines in this area, or to design several zones with different heating properties, due to different selected lengths for the heating wires and/or heating lines.

A homogeneous heating may be important for example for demisting applications because, if the heating is not homogeneous, water which evaporates from a strongly heated zone can condensate again on a less heated zone, so that efficient demisting may not be achieved.

For deicing applications, a non-homogeneous heating is also problematic as some zones may reach a sufficient temperature for deicing while others do not, so that efficient deicing may not be achieved.

Simply increasing the overall heating power for deicing with a non-homogeneous heating would however be inefficient and result in wasting energy, because some zones would be heated above the required temperature.

For applications as antennas, controlling the length of the wires/lines of the electrically conductive elements may also be important, because this may allows to vary the antenna design easily.

It is therefore the object of the present invention to provide a method for patterning electrically conductive elements, so that the annoyance resulting from the glare and/or from appearing diffraction patterns under strong lighting conditions may be considerably reduced, while also allowing to tune the length of the wires/lines of the electrically conductive elements.

This is done by the method for patterning electrically conductive elements according to claim 1.

Other advantageous embodiments of the present invention are described by the dependent claims 2 to 9.

Moreover the invention concerns patterned electrically conductive elements according to claim 11.

Other advantageous embodiments of the patterned electrically conductive elements are described by the dependent claims 12 to 27.

The method for patterning electrically conductive elements according to the present invention comprises that at least two segments preferably linked by at least one linking segment are arranged either randomly shifted to one or to other side of an average position or shifted alternating to one side or to the other side of an average position with a randomly selected shifting amplitude. This may allow to get the randomization required to reduce the annoyance resulting from the glare and/or from appearing diffraction patterns under strong lighting conditions considerably, while also allowing to tune the length of the wires/lines of the electrically conductive elements.

The method for patterning electrically conductive elements according to the present invention may be applied to any kind of electrically conductive element comprising at least one line, including electrically conductive elements and especially heating elements or antennas comprising lines and consisting of laminated or deposited metallic wires, metallic lacquers, like for example silver lacquer, or oxide-based coatings.

The method for patterning electrically conductive elements according to the present invention may furthermore for example be used for producing heating elements and/or antennas.

An electrically conductive element however comprises at least one electrically conductive layer.

Although the patterns selected for at least one electrically conducting layer of an electrically conductive element comprise at least one line and optionally other elements, the patterns may be of any desired dimension, form and shape.

However, any method for patterning an electrically conductive element may have at least comprise the steps of:
- planning the design of the desired pattern of the patterned electrically conductive element;
- patterning the electrically conductive element according to the planned design.

The planning of the design may be done before or while factoring the patterned electrically conductive element according to the planned design.

Moreover, the design of the desired pattern of the patterned electrically conductive element may be selected depending of the intended use.

The path of the line(s) comprised by the pattern of the electrically conductive element may be generated using different parameters like for example the length, the width, the curvature, the starting or ending points of the line(s), the number of segments per line, the elongation, the spacing between the lines and/or planned lines and/or other elements, the way segments are shifted alternating or randomly, the shifting amplitude and/or the parameters defining the function used to select the shifting amplitude, so that it/they comprise at least two segments linked by at least one linking segment are arranged either randomly shifted to one or to other side of the corresponding of an average position, which may be represented by the corresponding planned line, or shifted alternating to one side or to the other side of an average position, which may be represented by the corresponding planned line, with a randomly selected shifting amplitude. This may allow to get the randomization required to reduce the annoyance resulting from the glare and/or from appearing diffraction patterns under strong lighting conditions considerably, while also allowing to tune the length of the wires/lines of the electrically conductive elements.

When the design of the pattern electrically conductive element may comprise at least one line with a complicated path, the path of this/these line(s), which is part of the design of the desired pattern, may be planned using at least one planned line(s) before or while patterning the electrically conductive element according to the planned design.

Lines in the sense of the present invention may comprise any preferably planar pathway passing through at least two points of a same plane, especially straight lines, curved lines, loops or lines with a meander-like form, included lines with sinusoidal or cosinusoidal form.

A Planned line in the sense of the present invention may correspond to an average position around which at least two segments preferably linked by a linking segment are arranged shifted to one or to another side of this average position represented by the planned line. Planned lines may therefore also correspond to the intended path of the lines, which are part of the design of the desired pattern while planning the design of the desired pattern of the electrically conductive element, especially when the design comprises at least one line with a complicated path.

The layout of the line(s) and of the planned line(s) may vary according to the intended use of patterned electrically conductive element. If a use as antenna may be intended, the layout of the planned lines comprised by the planned design of the desired pattern, which may optionally comprise other elements, may be loop-like. On the other hand, if a use as heating element may be intended the layout of the planned lines comprised by the planned design of the desired pattern, which may optionally comprise other elements, may be straight or waveform-like. However, the planned design of the desired pattern and the layout of the planned lines may preferably be functional, which means that the electrically conductive elements resulting there from may be used in the intended way.

When the design of the pattern electrically conductive element comprises at least one line with a complicated path and the path of this/these line(s), which is part of the design of the desired pattern, is planned using at least one planned line(s), at least one additional step of dividing the planned line(s) in at least two different segments before each segment, while remaining linked to the other segment(s) by a linking segment, may be either randomly shifted to one or to other side of the corresponding planned lines, which may represent an average position, or shifted alternating to one or to other side of the corresponding planned lines, which may represent an average position, with a randomly selected shifting amplitude.

This may allow to get the randomization required to reduce the annoyance resulting from the glare and/or from appearing diffraction patterns under strong lighting conditions considerably, while also allowing to tune the length of the wires/lines of the electrically conductive elements.

A line may comprise several and specially two or more then two segments. These segments may in some embodiments of the present invention be obtained by dividing a planned line into segments or be generated without dividing planned lines. A segment in the sense of the present invention is a part of a line or of a planned line defined for example preferably at least by it's length, by a shifting amplitude and by the, preferably exactly one, angle it or, when the segment is curved, a tangent to the middle of the segment, may define with the planned line or, when the planned line is curved, a tangent to the middle of the planned line or of the curved portion of the planned line, whereby at least the length of one segment, it's shifting amplitude or the, preferably exactly one, angle it or, when the segment is curved, a tangent to the middle of this segment, may define with the planned line or, when the planned line is curved, a tangent to the middle of the planned line or of the curved portion of the planned line may preferably be different respectively at least from the length of at least one bordering segment, at least from the shifting amplitude of at least one bordering segment or from the, preferably exactly one, angle at least one bordering segment or, when the segment is curved, a tangent to the middle of this segment , may define with the planned line or, when the planned line is curved, a tangent to the middle of the planned line or of the curved portion of the planned line. However, the segments may preferably be parallel to the planned line or, when the planned line is curved, to a tangent to the middle of the planned line or of the curved portion of the planned line. In preferred embodiments of the present invention, the length of each planned line may correspond to the sum of the lengths of the segments preferably before shifting or even after shifting without accounting the linking segments, especially when the linking segments are perpendicular to planned lines. The segments may preferably be parallel and linked one to another by linking segments. In addition, segments are preferably arranged centred to the bordering segments and/or other elements in a direction, which may preferably be perpendicular to the direction of the lateral shift to one or to the other side of a planned line.

In some embodiments of the present invention, each segment may define an angle of between 0° and 90° with a corresponding planned line or, when the planned line is curved, with a tangent, preferably to the middle of a corresponding planned line or to the middle of a curved portion of a corresponding planned line. In some embodiments the angle defined by each segment with a corresponding planned line or, when the planned line is curved, with a tangent, preferably to the middle of a corresponding planned line or to the middle of a curved portion of a corresponding planned line may vary from at least one segment to at least one other segment. This may allow to even further increase the randomization to further reduce the annoyance resulting from the glare and/or from appearing diffraction patterns under strong lighting conditions.

Moreover, the segments may preferably be linked by linking segments as they have to remain linked together after they were arranged shifted to one or to the other side of a planned line to provide an electrically conductive pathway. This may be achieved by adding linking segments, preferably straight linking segments, of an appropriate length between consecutive segments of a line, preferably after they were arranged shifted to one or to the other side of a planned line, so that these linking segments may provide a link between these consecutive segments. A linking segment in the sense of the present invention may be a segment, preferably joining one end of a segment to one end of an other segment and further preferred joining one end of a segment to one end of an other segment bordering the first segment, provided to link two other segments one to another, for example when a gap is created between two segments by arranging the segments shifted to one or to the other side of a planned line, so that the segments comprised by a line may form a continuous pathway. Doing so may lead to an elongation of the lines compared to the planned lines, which means that their length is increased compared to the length of the planned lines by introducing the linking segments. The number of linking segments may thereby be equal to the number of segments comprised by the line(s) minus one. The maximum increase of the length or elongation of the planned lines after the shifting may be estimated equal or inferior to the mean value of the shifting amplitude plus 3, preferably 4 even further preferred 5 times the standard deviation of the shifting amplitude. This means that even if a random process is used, one may estimate and tune the maximum elongation easily, by selecting for example the mean value of the shifting amplitude and/or the distribution function of the shifting amplitude values.

This may allow to select the maximum elongation, which may mean the maximum length difference between a planned line and the corresponding line of the pattern of the electrically conducting element obtained after the shifting, by selecting for example the mean value of the shifting amplitude and/or the distribution function of the shifting amplitude values, so that the maximum length difference between to planned lines with the same length may for example at least in certain areas be between 0,001% and 200%, preferably between 0,001% and 100%, further preferred between 1% and 50%, even further preferred between 2% and 25% and even more preferred 2% and 10% of the length of these lines. Thereby it may be possible to get a patterned electrically conductive element, with a random pattern and comprising lines with a resistivity, which does selectively, preferably at least in certain areas, not differ from one to another line by more than for example between 0,001% and 200%, preferably between 0,001% and 100%, further preferred between 1% and 50%, even further preferred between 2% and 25% and even more preferred 2% and 10%, as the resistivity may depend mainly on the length of the lines (at least when the material used for the lines and the cross section, preferably defined by the thickness and the width, of the lines is the same). This may allow to control the homogeneity of the heating as the heating properties depend on the length of the lines (at least when the material used for the lines and the cross section, preferably defined by the thickness and the width, of the lines is the same).

In preferred embodiments of the method according to the present invention, the linking segments may be perpendicular to a corresponding planned lined and/or, when the planned line is curved, to a tangent, preferably to the middle of a corresponding planned line or to the middle of a curved portion of a corresponding planned line. This may help to minimize the elongation and thus the change of resistivity, while it also renders the estimation of the elongation very easy. This may be useful when big changes of resistivity are not desired, for example to allow the use of the electrically conductive elements with existing power supply systems without major changes to the design.

In other embodiments of the method according to the present invention, the linking segments may be placed so that each linking segment may define an angle between 0° and 90° with a corresponding planned line and/or, when the planned line is curved, with a tangent, preferably to the middle of a corresponding planned line or to the middle of a curved portion of a corresponding planned line, to a corresponding planned line, to achieve a good fitting of the lines of the electrically conductive elements to the planned lines. This may be useful to keep the design of the pattern functional, so that the resulting patterned electrically conducting elements used as it was intended during the planning of the design of the pattern give optimal results. Furthermore, this may also help to reduce the risk of the formation of hotspots during use, while providing randomization to reduce the annoyance resulting from the glare and/or from appearing diffraction patterns under strong lighting conditions.

However, when at least one linking segment defines an angle between 0° and 89° with the planned lines, the length of each planned line may be inferior or superior to the sum of the lengths of the segments preferably before shifting or even after shifting without accounting the linking segments to allow each linking segment to define an angle between 0° and 89° with the planned lines. In addition, the segments are preferably arranged centred to the bordering segments and/or other elements in a direction, which may preferably be perpendicular to the direction of the lateral shift to one or to the other side of a planned line.

In some embodiments of the present invention, when at least one linking segments define at least one angle between 0° and 89° with the planned lines and especially when the shifting amplitude is selected randomly, the length of each segment may be changed depending on the corresponding randomly selected shifting amplitude to get the selected angle(s).

Beside of that the angle defined by a linking segment with the planned lines may vary from at least one linking segment to at least one other linking segment in some embodiments of the present invention, especially when the shifting amplitude of each segment is selected randomly because the shifting amplitude may influence the angle defined by linking segments and the planned lines, so that the angle may vary depending on the selected shifting amplitude for each segment. This may allow to even further increase the randomization to further reduce the annoyance resulting from the glare and/or from appearing diffraction patterns under strong lighting conditions.

Moreover, in some embodiments of the invention and especially preferred, when the sum of the length of each planned line may be inferior or superior to the sum of the lengths of the segments preferably before shifting or even after shifting without accounting the linking segments, the segments may not only be shifted laterally to one or to the other side of the planned lines but also in the same plane and in a direction which is perpendicular to the lateral shift, so that the segments may be shifted upward or downward from their preferred position, which may be centred to the bordering segments and/or other elements in a direction, which may preferably be perpendicular to the direction of the lateral shift to one or to the other side of a planned line, in the plane of the lateral shift. This additional shift may be performed before or after the shift to one or to the other side of the planned lines. This may allow to even further increase the randomization to further reduce the annoyance resulting from the glare and/or from appearing diffraction patterns under strong lighting conditions.

Furthermore, the segments may be straight or curved, to achieve a good fitting of the lines of the electrically conductive elements to the planned lines. This may also be useful to keep the design of the pattern functional, so that the resulting patterned electrically conducting elements used as it was intended during the planning of the design of the pattern give optimal results.

In preferred embodiments of the method according to the present invention, the length of the segments may vary. This means that length of the segments may vary for example alternating, following a repeating or at least two alternating sequence(s) or even randomly. This may allow to even further increase the randomization to further reduce the annoyance resulting from the glare and/or from appearing diffraction patterns under strong lighting conditions.

In some embodiments of the method according to the present invention, the segments may be shifted with at least one given shifting amplitude. A shifting amplitude in the sense of the present invention may be the distance measured from the average position, represented by the planned line, to which a segment is arranged shifted to one or to the other side to this segment, which means the distance separating a segment from the corresponding planned line, or the distance between the preferred position of a segment, which is the position centred to the bordering segments and/or other elements in a direction, which may preferably be perpendicular to the direction of the lateral shift to one or to the other side of a planned line, and it's actual position.

In preferred embodiments of the method according to the present invention, the segments may be shifted to one or to other side of an everage position, which may be represented by a planned line, with an amplitude, which may be selected randomly, so that the randomization may be even further increased to further reduce the annoyance resulting from the glare and/or from appearing diffraction patterns under strong lighting conditions, while also allowing to tune the length of the lines.

The shifting amplitude may be the greatest distance measured between a segment after it was shifted and the corresponding segment of the planned line, before any shift.

In preferred embodiments of the method according to the present invention, the shifting amplitude may be selected randomly using a selected distribution function, preferably a Gaussian distribution function, of the shifting amplitude and a selected mean value of the shifting amplitude.

In preferred embodiments of the method according to the present invention, the standard deviation of the preferably Gaussian distribution function of the shifting amplitude may be selected equal to the average value of the shifting amplitude. This may allow to achieve an excellent randomization as the shifting amplitude may vary preferably between 1 and 3, preferably between 1 and 4, further preferred between 1 and 5, further preferred between 1 and 6, further preferred between 1 and 7 and even more preferred between 1 and 8 times the average value of the shifting amplitude.

In an even more preferred embodiments of the method according to the present invention, the shifting amplitude may be selected randomly in a preset range. This allows to adapt the shifting amplitude to the spacing between a line and/or a planned lined and another line and/or planned line and/or another element of planned the design of the desired pattern. This may prevent segments from eventually overlapping or colliding with shifted segments from (an) other line(s) and/or planned line(s) and/or other elements of the planned design of the desired pattern after the shifting.

The shifting amplitude may therefore preferably be selected randomly for example between 0 and 95%, preferably between 1 and 75%, further preferred between 3% and 65%, further preferred between 5% and 50% and even further preferred between 10% and 45% of the spacing between to adjacent lines and/or planned lines or of the spacing between a line and/or a planned line and another element of the planned design of the pattern. This prevents segments from eventually overlapping or colliding with shifted segments from (an) other line(s) and/or planned line(s) and/or other elements of the planned design of the pattern after the shifting.

Moreover selecting the shifting amplitude randomly in a preset range allows to tune the accuracy of the estimation of the length of the lines of the planned pattern design after shifting. Selecting a broad range for the shifting amplitude allows to increase the randomization, so that the annoyance resulting from the glare or from appearing diffraction patterns under strong lighting conditions is even further reduced, by selecting a broad range. However, doing so may also increase the standard deviation obtained for the elongation, so that the heterogeneity of the length of the lines may also be increased, which may mean that the accuracy of the estimation of the length of the lines after shifting and the homogeneity of the length and of the heating properties of the lines may be decreased. On the other hand, selecting a narrower range may allow less randomization but may decrease the standard deviation obtained for the elongation and increase the accuracy of the estimation of the length and the homogeneity of the length and the heating properties of the lines after shifting in areas.

In other preferred embodiments of the invention, the shifting amplitude may be related to the elongation. This means that a selected elongation may be chosen for the lines of at least one area of the patterned electrically conductive element to select preferably randomly the shifting amplitude using this selected elongation. The elongation in the sense of the present invention may be the increase in length of a part of a planned line and/or of a planned line. The elongation may preferably be selected as percentage of the length of a part of a planned line and/or of the planned line. This may also prevent segments from eventually overlapping or colliding with shifted segments from (an) other planned line(s) and/or other elements of the planned design of the pattern after the shifting, as the shifting amplitude is limited thereby.

Moreover, by selecting the elongation, one may tune the length and thereby the resistivity of the lines of the electrically conductive element. This means that by selecting different elongations for at least two areas of the electrically conductive element, one may get different heating properties for these areas. The difference between the lengths of the lines in at least two areas with different elongations, which may be directly correlated to the difference between the heating properties of these areas, may be estimated by using the corresponding mean value of the shifting amplitude and the corresponding distribution function of the shifting amplitude for each area. The maximum length difference for lines of at least two areas with different elongations may be estimated from the difference of the lowest mean value of the shifting amplitude minus 3, preferably 4, further preferred 5, further preferred 6, further preferred 7 and even more preferred 8 times the standard deviation of the shifting amplitude values in the area with the lowest elongation and the highest mean value of the shifting amplitude plus 3, preferably 4, further preferred 5, further preferred 6, further preferred 7 and even more preferred 8 times the standard deviation of the shifting amplitude in the area with the highest elongation. This may be useful to estimate or to increase the homogeneity of the heating properties, by selecting planned designs for the pattern, where this difference is as low as possible.

However, the difference between the heating properties of lines of the same length belonging to at least two areas with different elongations may preferably be estimated by the difference between the elongations, because these values may represent the mean increase of length in each area, corresponding to the mean change of the heating properties. This means that if one may want an area which heats two times stronger and/or quicker then another, one may select an elongation for the second stronger and/or quicker heating area, which is the double of the elongation of the first area, so that the mean length of the lines in one area becomes the double of the mean length of the lines in the other area.

In further preferred embodiments of the invention, the shifting amplitude may be related to the elongation per segment. In this case, the shifting amplitude may be preferably randomly selected for example in a range comprised between 1 and 10 times, preferably between 1 and 5 times, further preferred between 1 and 4 times even more preferred between 1 and 3 times the elongation per segment. The elongation per segment in the sense of the present invention may be equal to the total elongation of part of a line or a line divided by the number of segments comprised by this line. Furthermore, the elongation per segment may be considered as the mean value of the shifting amplitude. Increasing the shifting amplitude allows to increase the randomization, so that the annoyance resulting from the glare or from appearing diffraction patterns under strong lighting conditions is even further reduced, but it may also increase the standard deviation of the shifting amplitude, so that the length of the lines of the planned design may differ more after the shifting, so that the homogeneity of the length and of the heating properties of the lines after shifting in areas with the same elongation may be decreased.

Moreover, the lines obtained according to the method according to the invention may comprise for example in between 2 and 10000000, preferably 5 and 500000, further preferred 10 and 250000, further preferred 20 and 100000, further preferred 50 and 50000, further preferred 75 and 25000, further preferred 90 and 10000, further preferred 100 and 5000, further preferred 250 and 2500, even more preferred 500 and 1000 different segments. Increasing the number of segments, comprised by the lines may allow to increase the randomization, so that the annoyance resulting from the glare and/or from appearing diffraction patterns under strong lighting conditions is even further reduced, while also decreasing the standard deviation of the shifting amplitude, so that the homogeneity of the length of the lines with the same number of segments for the same length, the same selected mean value of the shifting amplitude and/or elongation may be increased. This allows to provide a more accurate estimation of the length of the lines after shifting while efficiently reducing the annoyance resulting from the glare and/or from appearing diffraction patterns under strong lighting conditions and to achieve a reduced difference between the length and the heating properties of two lines of an area with the same mean value of the shifting amplitude, corresponding to an increased homogeneity of the length and the heating properties for areas with the same mean value of the shifting amplitude and/or elongation.

In other preferred embodiments of the method according to the present invention the length of each individual line comprised by the pattern of the patterned electrically conductive elements after shifting may be calculated in each area with a given elongation for any given planned design of the desired pattern before selecting the designs, where the maximal length differences between the lines in any area with a given elongation and/or the differences between the elongations of at least two areas with different elongations and/or the maximal length differences between the lines of at least two areas with different elongations is/are inferior to a given value. The maximal length differences between the lines in any area with a given elongation and/or the differences between the elongations of at least two areas with different elongations and/or the maximal length differences between the lines of at least two areas with different elongations may therefore for example be inferior to 50%, preferably to 25%, further preferred to 20%, further preferred to 15%, even further preferred to 10%, even further preferred to 5%, even further preferred to 3%, more preferred to 1% and even more preferred to 0,1% of the average length of the lines. This may also allow calculating the resistivity and/or the power density of the pattern of the patterned electrically conductive elements in at least one area of the electrically conductive heating element, while selecting the designs falling in a given resistivity and/or power density range in at least one area of the electrically conductive heating element. Doing so may allow a certain randomization, while also achieving a precise control of the homogeneity of the heating properties and/or of the resistivity and/or of the power density in at least one area of the electrically conductive heating element.

Moreover, the spacing between the starting points and the ending points of at least a part of the lines and/or of the planned lines or between the starting point and the ending point of at least a part of the lines and/or of the planned lines and at least a part of other elements may vary. This means for example that the spacing between the starting points and the ending points of at least two lines and/or planned lines may be different from the spacing between the starting points and the ending points of at least two other lines and/or planned lines or from the spacing between the starting point and the ending point of at least one line and/or planned line and at least one other element or that the spacing between the starting point and the ending point of at least one line and/or planned line and at least one other element may be different from the spacing between the starting point and the ending point of at least one other line and/or planned line and at least one other element or from the spacing between the starting points and the ending points of at least two lines and/or planned lines. This may further increase the randomization, so that the annoyance resulting from the glare and/or from appearing diffraction patterns under strong lighting conditions is even further reduced.

In preferred embodiments of the method according to the present invention, the spacing between the starting point and the ending points of at least a part of the lines and/or planned lines or between the starting point and the ending point of at least a part of the lines and/or planned lines and at least a part of other elements may be selected preferably randomly using for example a selected distribution function, preferably a Gaussian distribution function and a selected mean value. This may even further increase the randomization, so that the annoyance resulting from the glare and/or from appearing diffraction patterns under strong lighting conditions is even further reduced.

In even more preferred embodiments of the method according to the present invention, the spacing between the starting points and the ending points of at least a part of the lines and/or planned lines or between the starting point and the ending point of at least a part of the lines and/or planned lines and at least a part of other elements may selected randomly in a preset range. This may allow to adapt the spacing to the shifting amplitude to prevent segments from eventually overlapping or colliding with shifted segments from (an) other line(s) and/or planned line(s) and/or other elements of the planned design of the desired pattern after the shifting.

The spacing between the starting points and the ending points of at least a part of the lines and/or planned lines or between the starting point and the ending point of at least a part of the lines and/or planned lines and at least a part of other elements may therefore preferably be selected randomly in a range with a lower limit higher or equal to the mean value of the shifting amplitude plus 3, preferably 4, further preferred 5, further preferred 6, further preferred 7 and even more preferred 8 times the standard deviation of the shifting amplitude values, to adapt the spacing to the shifting amplitude to prevent segments from eventually overlapping or colliding with shifted segments from (an) other line(s) and/or planned line(s) and/or other elements of the planned design of the desired pattern after the shifting.

The upper limit of the spacing may be set, so that the desired heating performance per surface unit may be achieved. Although a high upper limit may further increase randomization, so that the annoyance resulting from the glare and/or from appearing diffraction patterns under strong lighting conditions is even further reduced, it may also decrease the heating performance per surface unit simply because a upper limit for the spacing gives a higher mean value for the spacing, which may result in less heating lines and/or other elements and therefore less heating performance per surface unit.

The spacing between the lines and/or planned lines may for example be selected in a range between 101% and 1000000%, preferably between 150% and 100000%, further preferred between 200% and 10000% and even further preferred between 300% and 1000% of the mean shifting amplitude plus 3, preferably 4, further preferred 5, further preferred 6, further preferred 7 and even more preferred 8 times the standard deviation of the shifting amplitude values. This may prevent segments from eventually overlapping or colliding with shifted segments from (an) other planned line(s) and/or other elements of the planned design of the pattern after the shifting.

In some embodiments, at least one additional step of smoothing may be performed after arranging at least two segments linked by at least one linking segment either randomly shifted to one or to other side of the corresponding of an average position or shifted alternating to one side or to the other side of an average position with a randomly selected shifting amplitude. This may help to reduce the risk of the formation of hotspots during use, while also providing randomization to reduce the annoyance resulting from the glare and/or from appearing diffraction patterns under strong lighting conditions.

Beside of this, the patterning may for example be performed by depositing a wire, by applying some metallic lacquer or by etching, so that lines in the sense of the present invention may for example comprise wires, lacquer lines or lines of an electrically conductive layer

However, etching the desired pattern may allow to very easily obtain even complex patterns and/or patterns with very thin elements, for example very thin lines, which may not be easily obtained by depositing wires.

Complex patterns may for example comprise patterns comprising lines with different and/or varying line widths to get different resistivity values and therefore different heating properties, depending on the line width and on the subsequent resistivity value, for certain areas of the pattern. Using a pattern with different lines widths or with varying line widths may allows to create different zones with different heating properties, so called heating zones.

Moreover, in some preferred embodiments of the present invention, the thickness and the material of each electrically conductive layer may be different between two layers electrically conductive layers at least in certain areas and/or may vary within a electrically conductive layer at least in certain areas, so that zones with different resistivities and thus different heating properties, so called heating zones may be formed.

A heating zone in the sense of the present invention may have any form and may differ in heating properties and thus for example in resistivity from at least one boarding zone.

However as explained here before different heating zones may for example also be created by using different and/or varying angles defined by a planned line(s) and/or, when a planned line is curved, by a tangent, preferably to the middle of a corresponding planned line or to the middle of a curved portion of a corresponding planned line and the linking segments, different and/or varying distribution functions for the shifting amplitude, different mean values for the shifting amplitude, different and/or varying elongations, different and/or varying ranges for the shifting amplitude, different and/or varying numbers of segments corresponding to the same length, different values for the spacing between the starting points and the ending points of at least a part of the lines and/or planned lines or between the starting point and the ending point of at least a part of the lines and/or planned lines and at least one part of the other elements, (a) different and/or varying material(s) for at least one electrically conductive layer.

Different refers to differences between at least two lines (and/or layers) or at least parts thereof and varying refers to differences within a line (and/or layer). This means that the angles defined by a planned line and/or, when a planned line is curved, by a tangent, preferably to the middle of a corresponding planned line or to the middle of a curved portion of a corresponding planned line and the linking segments, the distribution functions for the shifting amplitude, the mean values for the shifting amplitude, the elongations, the ranges for the shifting amplitude, the number of segments corresponding to the same length of a planned line may vary within a line or be different between to lines to define at least two different heating zones.

In preferred embodiments of the present invention, patterning by etching may be performed for example using a laser or alternatively by through a series of photolithographic steps.

As lasers drain a lot electrical power and patterning using lasers may be relatively slow depending of the complexity of the desired pattern (and thus on the required laser movements), the movement speed of the lasers, the material that has to be patterned. A process using a series of photolithographic steps may for example preferably be used when a complex pattern and/or a high throughput is desired.

In such a process using a series of photolithographic steps at least one electrically conductive layer optionally fixed to at least one plastic support layer may for example be patterned through a series of photolithographic steps comprising:
- coating at least one electrically conductive layer with at least one photosensitive substance,
- exposing the photosensitive substance(s) to electromagnetic radiation in a certain area or in certain areas,
- removing either the non-exposed photosensitive substance(s) or the exposed photosensitive substance(s),
- etching the desired pattern into at least one electrically conductive layer,
- stripping of the remaining either exposed or non-exposed photosensitive substance(s).

Optionally there may be for example a step of subjecting the remaining either exposed or non-exposed photosensitive substance(s) to a heat treatment before the etching and after removing either the non-exposed photosensitive substance(s) or the exposed photosensitive substance(s).

There may optionally for example be a step stabilising, curing, baking the remaining either exposed or non-exposed photosensitive substance(s) before the etching and after removing either the non-exposed photosensitive substance(s) or the exposed photosensitive substance(s).

Optionally drying may be performed after each step and specially after coating the electrically conductive layer with at least one photosensitive substance and/or after stripping of the remaining either exposed or non-exposed photosensitive substance(s), using a heat treatment.

Each of these steps may be done one or repeated more then one time, as it may be useful. They may be performed at different temperatures, to accelerate or to slow down the desired reaction and/or effects. The steps of removing either the non-exposed photosensitive substance(s) or the exposed photosensitive substance(s) or of stripping of the remaining either exposed or non-exposed photosensitive substance(s) may be repeated several times to remove or to strip of the desired substance, so that no rests are remaining.

A photosensitive substance may for example be any substance usable or commonly used as photoresistive lacquer in photolithographic processes or variants thereof.

Electromagnetic radiation in the sense of the present invention may for example be any radiation with a wavelength comprised between 10 m and 10⁻¹⁷ m. In preferred embodiments, the wavelength of the radiation may be between 500 nm and 10⁻¹⁷ m. In preferred embodiments, the electromagnetic radiation may be UV-radiation. The electromagnetic radiation may therefore have preferably a wavelength comprised between 450 nm and 1 nm and even more preferably between 300 nm and 425 nm. It should be noted that wavelength of the electromagnetic radiation may also be at least one wavelength range within the previously cited ranges or comprise at least one or preferably at least two distinct wavelengths within the cited ranges.

In preferred embodiments of the present invention, the design of the desired pattern and/or the electrically conductive element comprises at least one electrical contact of any desired size and shape. This may be required, when the electrically conductive element is used for example as an antenna, to connect senders and/or receptors.

In preferred embodiments of the present invention, the contact(s) may be obtained by patterning the electrically conductive layer. This allows to simplify the production process by skipping a step of adding contacts.

An electrical contact in the sense of the present invention may be any preferably non-patterned area of the electrically conductive layer and of the electrically conductive element of any size or shape, which lends itself to establish an electrical connection to the electrically conductive element. It may for example be a rectangular area preferably placed at an edge of the electrically conductive element.

In some other preferred embodiments of the invention, the design of the desired pattern and/or the electrically conductive element comprises at least two different electrical contacts. This may be useful for example, when both receptors and senders have to be connected to an electrically conductive element used as antenna or when the design of the desired pattern and/or the electrically conductive element comprises two antennas, which require to different electrical contacts to connect senders and/or receptors.

In even more preferred embodiments of the present invention, the design of the desired pattern and/or the electrically conductive element comprises an electrically conductive pathway between at least two different electrical contacts. This allows electricity to flow from one electrical contact to the other(s) through the electrically conductive element.

This may for example be desirable when the electrically conductive element is used as heating element.

Moreover, the present invention also concerns patterned electrically conductive elements, which may be produced by the process according to the present invention. The electrically conductive elements according to the present invention may therefore comprise all the features arising from this process described here before.

This means that the electrically conductive elements according to the present invention may comprise at least one line comprising at least two segments, which may be either randomly shifted to one or to the other side of an average position or shifted alternating to one or to other side of an average position with a randomly selected shifting amplitude.

Moreover, the segments, which compose at least one line comprised by the electrically conductive elements according to the present invention, may be straight or curved, to achieve a good fitting of the line(s) comprised by the electrically conductive elements to the planned lines. This may also be useful to keep the design of the pattern functional, so that the resulting electrically conducting elements used as it was intended during the planning of the design of the pattern give optimal results.

The shifting amplitude of the segments, which compose at least one line comprised by the electrically conductive elements according to the present invention, may be selected randomly, preferably in a preset range, also when the segments are randomly shifted either to one or to other side of an average position. This may further increase the randomization, so that the annoyance resulting from the glare and/or from appearing diffraction patterns under strong lighting conditions is even further reduced.

Furthermore, the shifting amplitude of the segments comprised by the electrically conductive elements according to the present invention may be related to the elongation. This may even further increase the randomization, so that the annoyance resulting from the glare and/or from appearing diffraction patterns under strong lighting conditions is even further reduced.

The lines comprised by the electrically conductive elements according to the present invention may comprise between 2 and 10000000, preferably 5 and 500000, further preferred 10 and 250000, further preferred 20 and 100000, further preferred 50 and 50000, further preferred 75 and 25000, further preferred 90 and 10000, further preferred 100 and 5000, further preferred 250 and 2500, even more preferred 500 and 1000 different segments. Increasing the number of segments comprised at least one line of the electrically conductive elements may allow to increase the randomization, so that the annoyance resulting from the glare and/or from appearing diffraction patterns under strong lighting conditions is even further reduced, while also decreasing the standard deviation of the shifting amplitude, so that the homogeneity of the length of the lines with the same number of segments corresponding to the same length, the same selected mean value of the shifting amplitude and/or elongation may be increased.

The spacing between the starting points and the ending points of at least a part of the lines and/or planned lines comprised by the electrically conductive elements according to the present invention or between the starting point and the ending point of at least a part of the lines and/or planned lines comprised by the electrically conductive elements according to the present invention and at least a part of other elements comprised by the electrically conductive elements according to the present invention may vary preferably randomly, even more preferred randomly in a preset range, even further preferred randomly in a range with a lower limit higher or equal to the mean shifting amplitude plus 3, preferably 4, further preferred 5, further preferred 6, further preferred 7 and even more preferred 8 times the standard deviation of the shifting amplitude values. This may allow to adapt the spacing to the shifting amplitude to prevent segments from eventually overlapping or colliding with shifted segments from (an) other line(s) and/or planned line(s) and/or other elements of the planned design of the desired pattern after the shifting.

Moreover, the electrically conductive elements according to the present invention may comprise at least two heating zones created by using different and/or varying angles defined by a planned line(s) and/or, when the planned line is curved, by a tangent, preferably to the middle of a corresponding planned line or to the middle of a curved portion of a corresponding planned line and the linking segments, different and/or varying distribution functions for the shifting amplitude, different and/or varying mean values for the shifting amplitude, different and/or varying elongations, different ranges for the shifting amplitude, different and/or varying numbers of segments corresponding to the same length, different values for the spacing between the starting points and the ending points of at least a part of the lines and/or planned lines or between the starting point and the ending point of at least one part of the lines and/or planned lines and at least one part of the other element(s), a different and/or varying width of the line(s),(a) different and/or varying thickness(es) of at least one electrically conductive layer,(a)different and/or varying material(s) for at least one electrically conductive layer.

The electrically conductive elements according to the present invention may comprise at least one, preferably two different, electrical contact(s), which could preferably be obtained by patterning at least one electrically conductive layer. This may allow to achieve an extremely good and strong link between the electrically conductive element and the contact (s).

In some embodiments of the present invention there may by two or more electrically conductive layers at least in certain areas of the electrically conductive elements according to present invention. These layers may be of the same or of different materials. Furthermore, these layers may be of the same or of different thicknesses. This may allow to get different resistivity values and therefore for example different heating properties at least in certain areas of the electrically conductive element, to get areas with a faster and/or stronger heating.

In preferred embodiments of the present invention, the electrically conductive layer may be a metallic layer. The use of a metallic layer allows to reach higher conductivity and lower power consumption during heating. Moreover, metallic layers have good mechanical properties and especially they have a fairly wide elastical deformation range so that they may be deformed, for example bended, in a fairly wide amplitude range without permanent damage for the layer. This may render the handling of both the conductive layer fixed on the plastic support layer and of the final electrically conductive element easier when at least one metallic layer is used.

Moreover, the electrically conductive element according to the present invention may comprise at least one plastic support layer, which may be a polymeric support layer, fixed to the electrically conductive layer and used to provide the desired good mechanical properties to the electrically conductive element, so that it can be handled easily. The plastic support layers may be fixed only at one side of the electrically conductive layer, so that the patterning for example by etching may be performed from the side, which is free of plastic support layer.

The plastic support layer may ensure that the electrically conductive layer fixed on the plastic layer may be easily manipulated, preferably for example by rolls, bands, machines or automates, during the production process, preferably including patterning, especially etching, of the electrically conducting element according to the present invention. Beside this, the plastic support layer may also ensure that the electrically conducting element comprising the patterned electrically conductive layer is easily handled and stored after its production. As the electrically conductive layer may be fixed to the plastic support layer, the plastic support layer helps keeping the desired pattern once it became patterned. Without, fixing both layers together problems may arise after the patterning because depending on the desired pattern and especially when it comprises very small and/or thin lines and/or elements the mechanical properties and the mechanical strength of the electrically conductive layer may decrease strongly. In this case, the fixed plastic support layer dramatically may reduce the risk of undesired local distortions of the patterned electrically conductive element, like for example the twisting of some lines and/or elements or undesired folding of some lines and/or elements.

In some preferred embodiments of the present invention, there may be two or more then two plastic support layers at least in certain areas. These layers may be of the same or of different materials. Furthermore, these layers may be of the same or of different thicknesses. This allows to reinforce the plastic support layer at least in certain areas, which may mainly be implied during manipulation operations. Using stronger materials and/or thicker layers and/or an increasing number of layers may allow to get an increased mechanical resistance in areas, which are particularly stressed during manipulation operations. Moreover more than one plastic support layer may allow to combine the properties of different materials of several layers to get the desired properties, so that for example one layer of a fairly heat resistant material, which might have poor chemical resistance, may be used together with a layer of a material providing good chemical resistance but a poor heat resistance to get the desired properties.

Furthermore, if at least two plastic support layers are used one may be used to provide good mechanical properties and fair chemical- and heat resistance, while another plastic support layer may be used to provide other properties like for example adhesion enhancing or radiation absorbing/filtrating properties. In this case, one layer may be used as UV- or IR-filter, to protect underlying layers or to reduce the glasshouse effect or to enhance adherence of the electrically conductive element to substrates or to additional layers like for example glass panes. A plastic support layer providing good mechanical properties and fair chemical- and heat resistance like for example a polyethylene terephtalate (PET) or polyethylene naphtalate (PEN) layer may for example be combined to a polyvinylbutyral (PVB) layer, so that the adhesion of the electrically conductive element to glass panes is enhanced for example during the lamination for the production of laminated glazing.

However, the plastic support layer may be fairly heat resistant, fairly resistant to chemicals and have good mechanical properties. Fairly heat resistant in the sense of the present invention means that it lends itself to stay between glass panes during lamination and the subsequent heat treatment to get laminated glazing. The plastic support layer may thus be fairly heat resistant to avoid the formation of bubbles or to avoid the deformation of the electrically conductive element by shrinking during the heat treatment performed in the production of laminated glazing.

Fairly resistant to chemicals in the sense of the present invention means that the plastic support layer may be resistant to etchants, photosensitive substances and commonly used washing solution (including for example sodium hydroxide solutions) commonly used in photolithographic processes. This may allow to enhance the mechanical resistance of the electrically conductive layer during the production process of the electrically conductive element, beside of ensuring an easy handling of the electrically conducting elements after their production.

Good mechanical properties in the sense of the present invention may be given when the plastic support layer does for example not be deformed permanently, form crack or rip during common manipulating operation and/or storing, such for example as the manipulating operation used to incorporate the electrically conducting element into laminated glazing.

In a preferred embodiment of the present invention the plastic support layer may comprise olefin based polymers or copolymers, which provide fair heat resistance, fair resistant to chemicals and good mechanical properties. These polymers may further comprise one ore more then one additives, which could for example be plasticizers, colorants, antioxidants, UV or IR-absorbing compounds, ...

These additives may allow to increase flexibility, to provide some colours, to increase the stability of the plastic support layer and/or to absorb undesired radiation.

High flexibility of the plastic support layer may be desired to provide good mechanical properties. A more flexible plastic support layer may perform better, as it is not so prone to rip or form cracks, during manipulating operation as a less flexible one.

Colours may be desired at least in some areas, for example to avoid blending phenomena. In preferred embodiments, this may be done by providing for example a plastic support layer with a dark coloured stripe preferably at one edge.

Antioxidants may provide an increased stability of the plastic support layer during time this may be useful for example to keep transparency while aging.

UV and IR absorbing compounds may be used both for increasing to protection of underlying layers from the corresponding radiation and to reduce the glasshouse effect when the electrically conductive element is used for example in glazing applications.

In a preferred embodiment of the present invention, the electrically conductive element may be at least partially transparent.

Transparent in the sense of the present invention means that it meets the transparency requirements for car glazing. These requirements may be different from country to country or from region to region depending on national law or regional law.

Partially transparent or highly transparent in the sense of the present invention means that more then 50%, preferred between 70% to 100%, specially preferred between 80% and 100%, even more preferred between 85% and 95% of the surface area of the electrically conductive element is transparent or highly transparent in the sense of the present invention.

In a preferred embodiment of the present invention, the electrically conductive element may be at least partially highly transparent.

Highly transparent in the sense of the present invention means that it meets the transparency requirements for windshields. These requirements are particularly high and as the visibility of the car driver may not to be hindered.

However, transparent or highly transparent in the sense of the present invention may preferably mean having a transmission higher than 50%, preferably higher than 60%, further preferred higher than 70%, specially preferred higher than 80%, further preferred higher than 90% and even further preferred higher than 95% in the visible wavelength range, preferably in the wavelength range from a bout 380 nm to 750 nm.

In preferred embodiments of the present invention, the plastic support layer may therefore be at least partially transparent and/or highly transparent.

Using an at least partially transparent o partially highly transparent plastic support layer may allow to consider the use of the electrically conductive elements in/on car glazing.

In preferred embodiments of the present invention the plastic support layer may comprise polyethylene terephtalate (PET) or polyethylene naphtalate (PEN), which provide good mechanical properties and fair heat and chemical resistance, although PEN may provide an increased heat resistance.

At least one electrically conductive layer may be fixed to at least one plastic support layer in any convenient way. However to fix at least one electrically conductive layer at least one plastic support layer, one may preferably for example partially embed the conductive layer into the plastic support layer or one may glue the electrically conductive layer to the plastic support layer.

The conductive layer may be at least partially embedded into the plastic support layer for example by laminating these layers together optionally while heating.

If the electrically conductive layer is glued to the plastic support layer, the requirements for the glue may be the same as the requirements for the plastic support layer.

In preferred embodiments of the present invention, the glue may be transparent or highly transparent.

As they meet these requirements, both polyolefin and polyurethane based glues may for example be used.

In preferred embodiments of the present invention, polyolefin based glues are used as they may have a better chemical resistance and a better long-term stability.

Moreover, in an even more preferred embodiment of the present invention the glue may be based on the same material as the plastic support layer. This increases the compatibility of the glue and the plastic support layer and provides a stronger and longer lasting gluing.

The glue may for example be selected from polyethylene-based glues.

Furthermore the glue may comprise one or more components with or without at least one additive such as cross-linking agents, viscosity adjusting agents, tackifiers, colorants, antioxidants, UV or IR-absorbing compounds to stronger and/or quicker gluing and/or longer lasting gluing. Furthermore, glues with more then one component may be easier to handle as they work as glues only when at least two components are in contact.

The production process may comprise subjecting at least one conductive layer fixed on at least plastic support layer to patterning to obtain at least one patterned electrically conductive layer with the desired pattern.

The resistance may therefore for example depend on the length (or on the mean length) of the pathway between at least two electrical contacts, the thickness (or on the mean thickness) of the electrically conductive layer, on the cross section of the pathway and on the material used as electrically conductive layer.

Each electrically conductive layer may have a thickness between 5 µm and 200 µm. Increasing the thickness may increase the mechanical resistance of the layer and of the whole electrically conductive element. On the other hand, a layer with an increased thickness may be visually more obstructive then a thinner layer after patterning. The thickness of the electrically conductive layer may therefore preferably be between 7,5 µm and 100 µm, specially preferred between 7,5 µm and 50 µm and even more preferred between 7,5 and 20 µm. Electrically conducting layers with a thickness higher than for example 50 µm may lead to patterned electrically conducting layers which are visually to obstructive for certain applications.

In preferred embodiments of the present invention, the electrically conductive layer may be a metallic layer.

In even further preferred embodiment of the present invention the electrically conductive layer may comprise at least, one metal selected from: gold, silver, tungsten, copper, aluminium, a metal alloy like for example steel or an iron-nickel alloy. These metals are specially preferred because of their low resistivity combined with a good mechanical resistance. The resistivity of silver, copper, gold, aluminium and tungsten is especially low. This may be desirable when the use of the electrically conducting element as heating element is intended to provide strong heating with low applied tension. Moreover copper, aluminium and tungsten have specially good mechanical properties, so that the mechanical resistance of very thin and/or small elements may be increased using this metals, to avoid problems during manipulation operations. Moreover, tungsten is very heat resistant, so that high temperatures may be reached during the use as heating element even thin lines or small elements, without the risk of melting.

In a preferred embodiment of the present invention, each plastic support layer has a thickness between 10 µm and 1000 µm, preferred between 10 µm and 500 µm, specially preferred between 25 µm and 250 µm and even more preferred between 40 µm and 150 µm. An increased thickness of the plastic support layer provides a better mechanical resistance, thereby avoiding problems during manipulation operation. On the other hand, an increased thickness of the plastic support layer may become a problem when certain applications are intended. When the use of the electrically conductive element as heating element for example within a laminated glazing is intended, a thick plastic support layer may lead to the formation of a plastic material bulging at the border of the glass pane during lamination. This border has to be removed in an additional production step, when this is too big.

In some preferred embodiments of the present invention, the thickness of each plastic support layer may vary at least in certain areas, so that for example areas which are particularly stressed during handling operation may be reinforced using a higher plastic support layer thickness.

In preferred embodiment of the present invention the patterned electrically conductive layer obtained by the process comprises lines or other elements with a width between 3 µm and 40 µm, preferred between 3 µm and 25 µm specially preferred between 3 µm and 15 µm, even more preferred between 5 µm and 15 µm, further preferred between 7,5 µm and 12,5 µm and even further preferred between 8 µm and 12 µm.

Using smaller widths allows to obtain a less visually obstructive electrically conductive element and helps achieving transparency. However, using small widths increases the risk of breaking elements and/or lines during manipulation operations and/or during the patterning, preferably by etching.

However, lines and/or elements, which are smaller and/or thinner than 15 µm, cannot be seen anymore by the naked eye even from a distance of less then 1 m preferably less then 60 cm, because of the limited resolution of the human eye. Using such elements permit to get really low visual obstruction and transparency or high transparency. Moreover, using lines and/or elements, which are smaller and/or thinner than 3 µm, may cause problems because of the limited accuracy of the etching process, limited to and accuracy of about 2 µm, preferably 1 µm. Using smaller and/or thinner lines and/or elements may lead to interrupted lines and/or elements after the patterning process, preferably by etching.

In preferred embodiments of the present invention, the patterned electrically conductive layer obtained by the process according to the present invention comprises lines or other elements that may be blacked in an additional step of the production process, so that they become visually less obstructive, as they are not so easily seen. The lines or elements may for example be blacked using pigments, colours or by oxidation.

Finally, the present invention concerns the use of the electrically conductive elements according to the present invention on glazing or within laminated glazing. The electrically conductive elements may be glued or laminated on glazing.

Within laminated glazing means between two panes of glass.

In preferred embodiments of the invention, electrically conductive elements according to the present invention may be used combined to at least one PVB sheet and two glass panes to produce laminated glazing.

The electrically conductive elements according to the present invention may thereby be used for example as antennas and/or or as heating elements within the laminated glazing.

The glazing, which may be heated or become equipped with an antenna using the electrically conductive element according to the present invention, may for example be vehicle glazing, specially car glazing including windshields and/or rear windows or the glazing of other vehicles like aircrafts, ships, space shuttles,...

Moreover, exterior glazing elements used for example for claddings may also be heated or equipped with an antenna using the electrically conductive element according to the present invention.

Finally glazing elements for interior applications, may be heated or equipped with an antenna using the electrically conductive element according to the present invention to get transparent elements, which may replace classical radiators, or classical antennas.

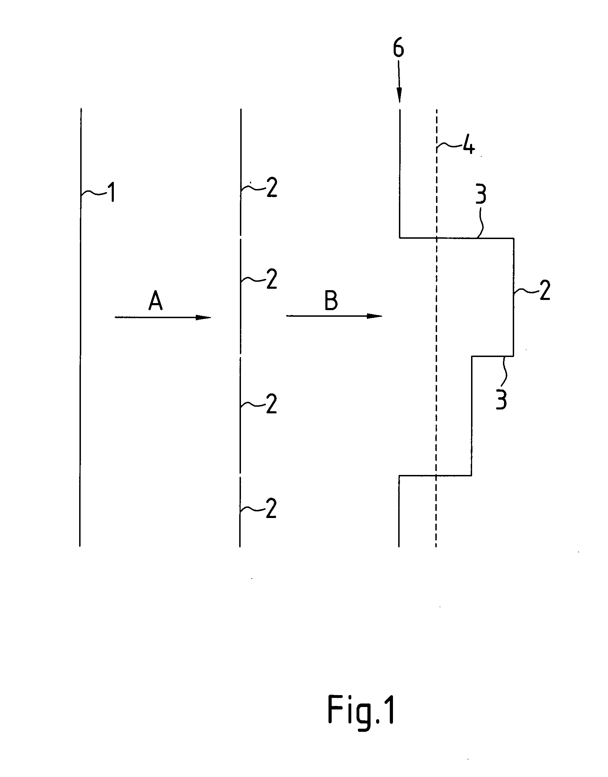

Fig. 1 shows a schematic representation of an example of one embodiment of the method for patterning electrically conductive elements comprising a line (6) according to the present invention, where a part of a planned line (1) is divided in 4 segments (2) in step A, so that the length of the part of the planned line may correspond to the sum of the lengths of the segments. In step B, each segment (2), while remaining linked to the other segment(s) (2) by linking segments (3) which are perpendicular to the part of the planned line (1) represented by the doted line, is randomly shifted to one or to other side of the corresponding part of the planned line, which may represent an average position (4), with a randomly selected shifting amplitude.

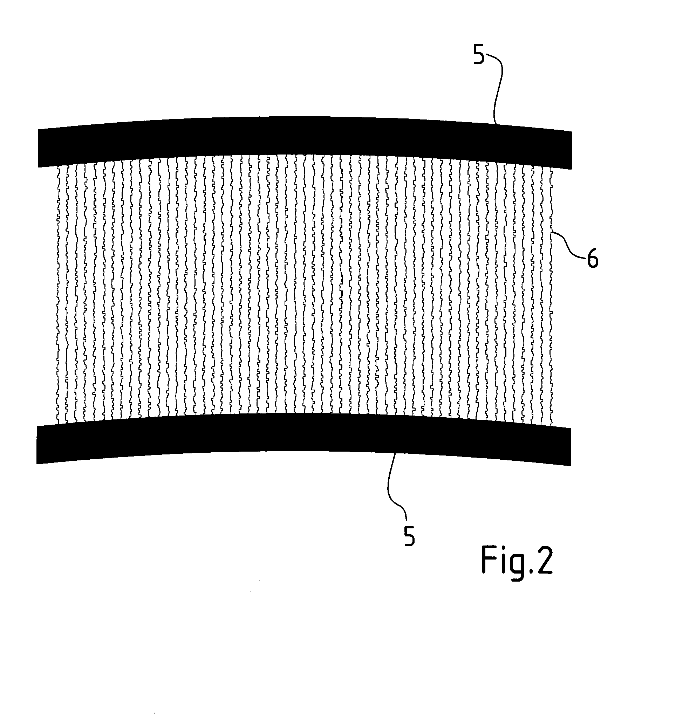

Fig. 2 shows a schematic representation of an example of an electrically conductive element, which may be obtained by the method according to the present invention, comprising curved electrical contacts (5) respectively at the top and at the bottom edge, to allow a good fitting of the form of the electrically conductive element for example to the form of the windshield glazing. The lines (6) may have a length between 500 and 750, preferably between 600 mm and 700 mm to fit to the width of a windshield and/or a rear window and the length of the electrically conductive element may fit the length of a windshield and/or a rear window. The randomization of the lines (6) is also shown in this schematic representation.

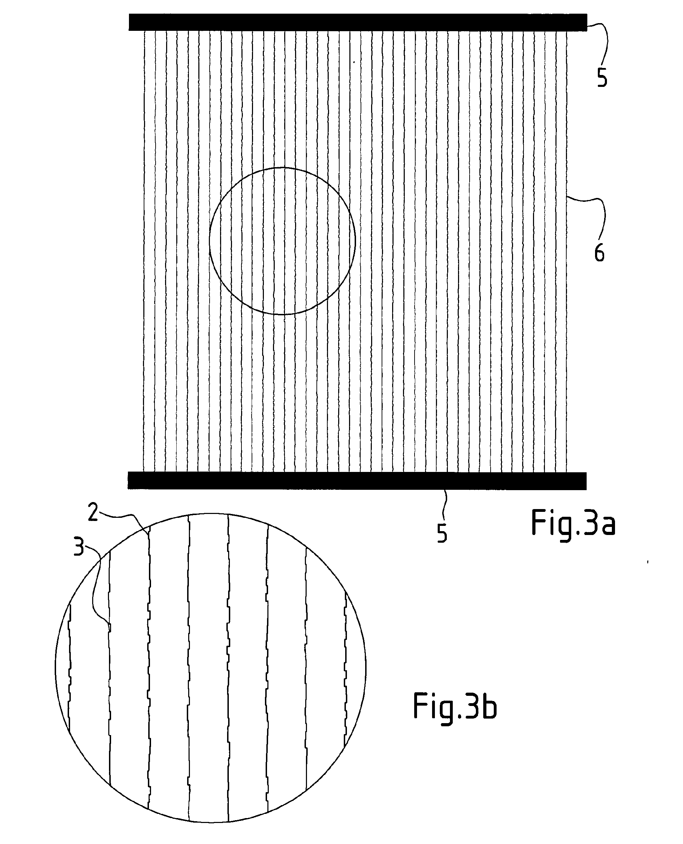

Fig. 3a shows a schematic representation of an example of a pattern of an electrically conductive element comprising two electrical contacts (5) and lines (6) obtained by the method according to the present invention with an elongation of 10% from a planned design of the desired pattern with forty 100 mm long straight planned lines, a spacing between the starting and the ending point of the planned lines of 2.46 mm between the starting and the ending points of the planned lines and 200 straight segments (2) per line (6), linked by straight linking segments (3), which are perpendicular to the corresponding planned lines, randomly shifted to one or other side of the planned lines with a shifting amplitude selected randomly using a distribution function described by a mean value equal to the elongation per segment and a standard deviation of 0.05 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 3a does not belong to the pattern of the electrically conductive element obtained by the method according to the present invention. It should only determine the part of the electrically conductive element obtained by the method according to the present invention shown in Fig. 3a which is shown with more details and a greater magnification in Fig. 3b.

Fig. 3b shows a detailed and magnified schematic representation of the part comprised in the circle shown in Fig. 3a of the pattern of an electrically conductive element obtained by the method according to the present invention shown in Fig. 3a. The segments (2), which are in this case parallel to the planned lines, and the linking segments (3), which are in this case perpendicular to the planned lines, can be seen in this detailed and magnified representation.

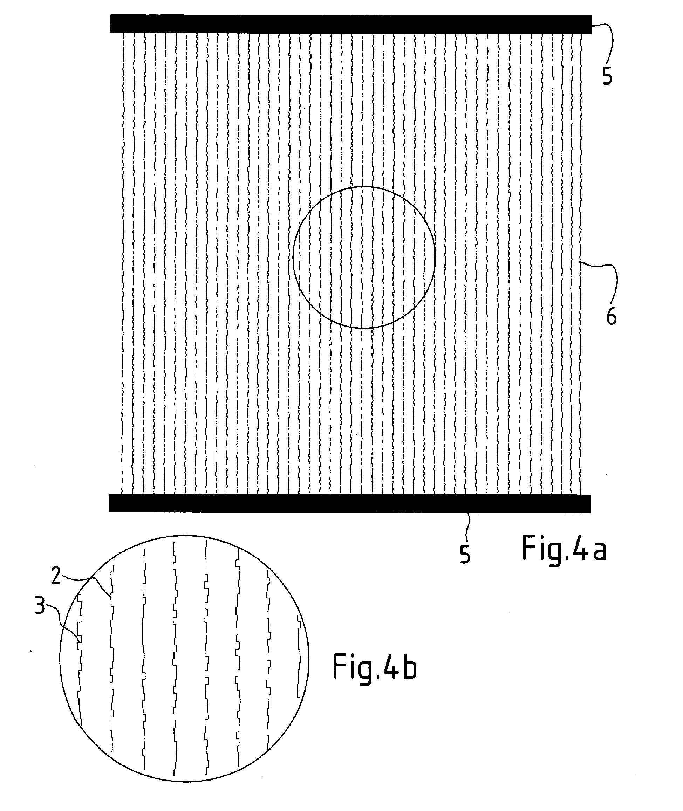

Fig. 4a shows a schematic representation of an example of a pattern of an electrically conductive element comprising two electrical contacts (5) and lines (6) obtained by the method according to the present invention with an elongation of 20%, from a planned design of the desired pattern with forty-five 100 mm long straight planned lines a spacing between the starting and the ending point of the planned lines of 2.25 mm between the starting and the ending points of the planned lines and 200 straight segments (2) per line (6), linked by straight linking segments (3), which are perpendicular to the corresponding planned lines, randomly shifted to one or other side of the planned lines with a shifting amplitude selected randomly using a distribution function described by a mean value equal to the elongation per segment and a standard deviation of 0.1 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 4a does not belong to the pattern of the electrically conductive element obtained by the method according to the present invention. It should only determine the part of the electrically conductive element obtained by the method according to the present invention shown in Fig. 4a which is shown with more details and a greater magnification in Fig. 4b.

Fig. 4b shows a detailed and magnified schematic representation of the part comprised in the circle shown in Fig. 4a of the pattern of an electrically conductive element obtained by the method according to the present invention shown in Fig. 4a. The segments (2), which are in this case parallel to the planned lines, and the linking segments (3), which are in this case perpendicular to the planned lines, can be seen in this detailed and magnified representation.

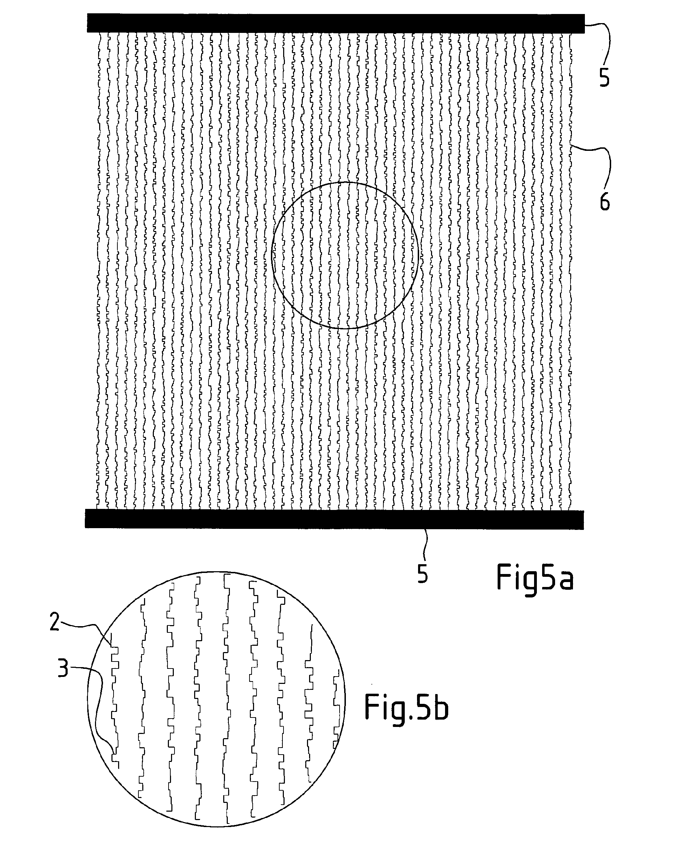

Fig. 5a shows a schematic representation of an example of a pattern of an electrically conductive element comprising two electrical contacts (5) and lines (6) obtained by the method according to the present invention with an elongation of 40% from a planned design of the desired pattern with fifty-two 100 mm long straight planned lines with, a spacing of 1.93 mm between the starting and the ending points of the planned lines and 200 straight segments (2) per line (6), linked by straight linking segments (3), which are perpendicular to the corresponding planned lines, randomly shifted to one or other side of the planned lines with a shifting amplitude selected randomly using a distribution function described by a mean value equal to the elongation per segment and a standard deviation of 0.2 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 5a does not belong to the pattern of the electrically conductive element obtained by the method according to the present invention. It should only determine the part of the electrically conductive element obtained by the method according to the present invention shown in Fig. 5a which is shown with more details and a greater magnification in Fig. 5b.

Fig. 5b shows a detailed and magnified schematic representation of the part comprised in the circle shown in Fig. 5a of the pattern of an electrically conductive element obtained by the method according to the present invention shown in Fig. 5a. The segments (2), which are in this case parallel to the planned lines, and the linking segments (3), which are in this case perpendicular to the planned lines, can be seen in this detailed and magnified representation.

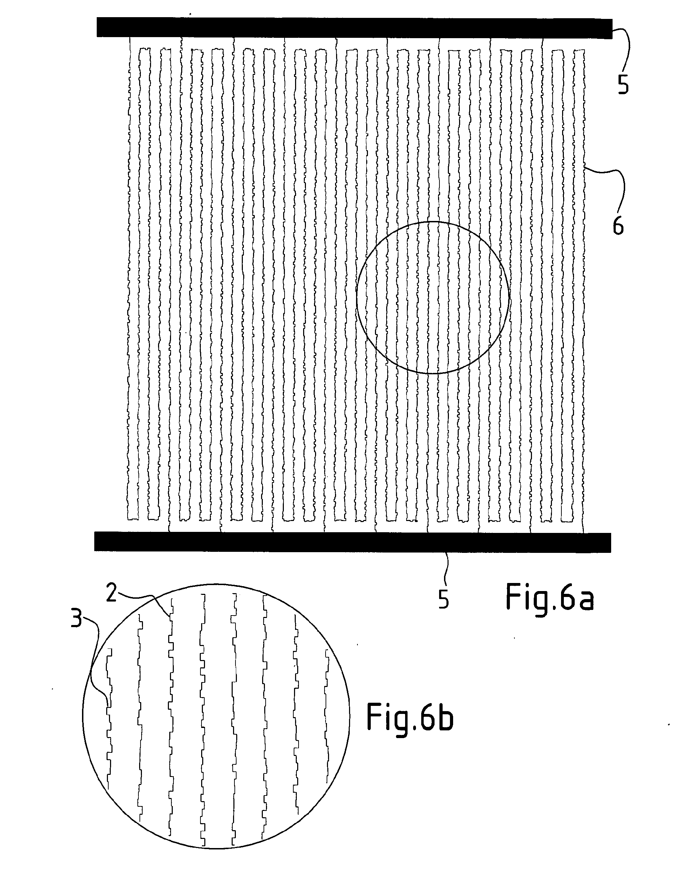

Fig. 6a shows a schematic representation of an example of a pattern of an electrically conductive element comprising two electrical contacts (5) and lines (6) obtained by the method according to the present invention with an elongation of 25% from a planned design of the desired pattern with 9 loops, each comprising 9 planned lines (5 vertical and 4 horizontal planned lines), with a total length 500 mm, a spacing of 2.08 mm between the starting and the ending points of the vertical planned lines and 1000 straight segments (2) per loop, linked by straight linking segments (3), which are perpendicular to the corresponding planned lines, randomly shifted to one or other side of the planned lines with a shifting amplitude selected randomly using a distribution function described by a mean value equal to the elongation per segment and a standard deviation of 0.125 mm. It should be understood that this electrically conductive element as well as the pattern might also be scaled up, for example to fit to the whole surface of a glazing element and especially a windshield or a rear window. The circle shown in Fig. 6a does not belong to the pattern of the electrically conductive element obtained by the method according to the present invention. It should only determine the part of the electrically conductive element obtained by the method according to the present invention shown in Fig. 6a which is shown with more details and a greater magnification in Fig. 6b.

Fig. 6b shows a detailed and magnified schematic representation of the part comprised in the circle shown in Fig. 6a of the pattern of an electrically conductive element obtained by the method according to the present invention shown in Fig. 6a. The segments (2), which are in this case parallel to the planned lines, and the linking segments (3), which are in this case perpendicular to the planned lines, can be seen in this detailed and magnified representation.

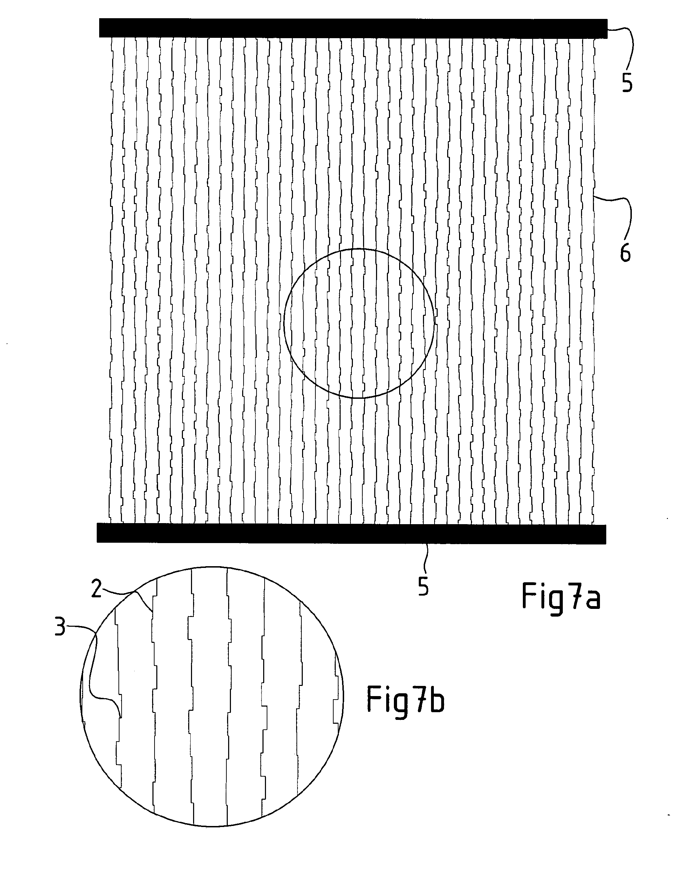

Fig. 7a shows a schematic representation of an example of a pattern of an electrically conductive element comprising two electrical contacts (5) and lines (6) obtained by the method according to the present invention with an elongation of 10% from a planned design of the desired pattern with forty-one 100 mm long straight planned lines, a spacing of 2.46 mm between the starting and the ending points of the planned lines and 63 (62 segments with a length of 1.6 mm and 1 segment with a length of 0.8 mm) straight segments (2) of varying length per line (6), linked by straight linking segments (3), which are perpendicular to the corresponding planned lines, randomly shifted to one or other side of the planned lines with a shifting amplitude selected randomly using a distribution function described by a mean value equal to the 0.16 mm and a standard deviation of 0.16 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 7a does not belong to the pattern of the electrically conductive element obtained by the method according to the present invention. It should only determine the part of the electrically conductive element obtained by the method according to the present invention shown in Fig. 7a which is shown with more details and a greater magnification in Fig. 7b.

Fig. 7b shows a detailed and magnified schematic representation of the part comprised in the circle shown in Fig. 7a of the pattern of an electrically conductive element obtained by the method according to the present invention shown in Fig. 7a. The segments (2), which are in this case parallel to the planned lines, and the linking segments (3), which are in this case perpendicular to the planned lines, can be seen in this detailed and magnified representation.

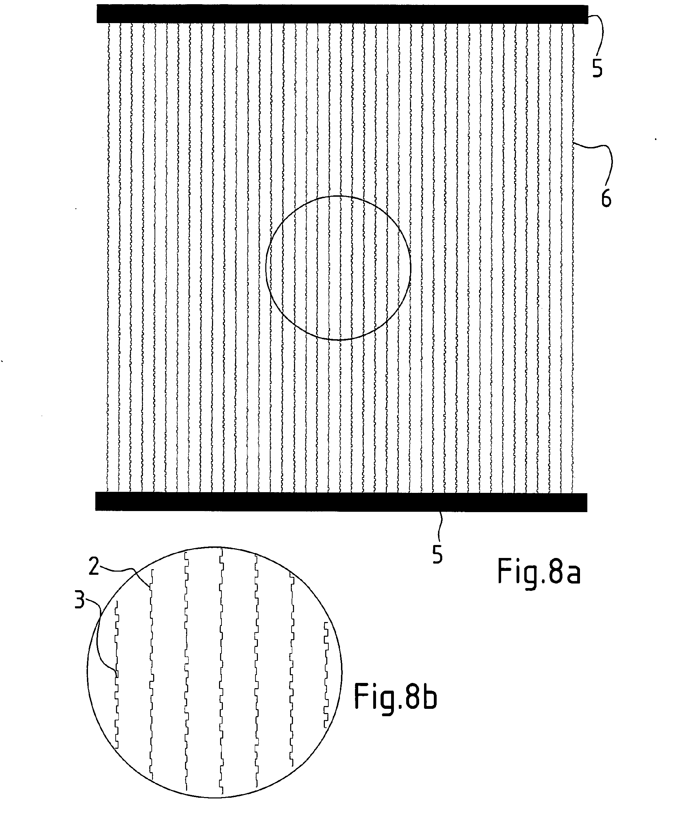

Fig. 8a shows a schematic representation of an example of a pattern of an electrically conductive element comprising two electrical contacts (5) and lines (6) obtained by the method according to the present invention with an elongation of 30% from a planned design of the desired pattern with forty-one 100 mm long straight planned lines, a spacing of 2.46 mm between the starting and the ending points of the planned lines and 200 straight segments (2) per line (6), linked by straight linking segments (3), which are perpendicular to the corresponding planned lines, randomly shifted and alternating to one or other side of the planned lines with a shifting amplitude selected randomly using a distribution function described by a mean value equal to the elongation per segment and a standard deviation of 0.15 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 8a does not belong to the pattern of the electrically conductive element obtained by the method according to the present invention. It should only determine the part of the electrically conductive element obtained by the method according to the present invention shown in Fig. 8a which is shown with more details and a greater magnification in Fig. 8b.

Fig. 8b shows a detailed and magnified schematic representation of the part comprised in the circle shown in Fig. 8a of the pattern of an electrically conductive element obtained by the method according to the present invention shown in Fig. 8a. The segments (2), which are in this case parallel to the planned lines, and the linking segments (3), which are in this case perpendicular to the planned lines, can be seen in this detailed and magnified representation.

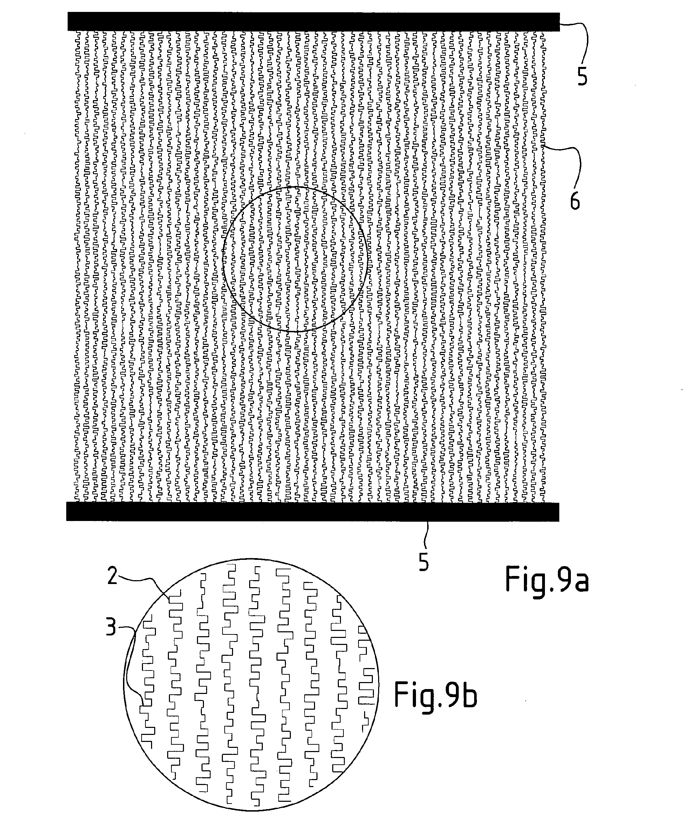

Fig. 9a shows a schematic representation of an example of a pattern of an electrically conductive element comprising lines (6) and two electrical contacts (5) obtained by the method according to the present invention with an elongation of 120% from a planned design of the desired pattern with fifty-two 100 mm long straight planned lines, a spacing of 1.93 mm between the starting and the ending points of the planned lines and 200 straight segments (2) per line (6), linked by straight linking segments (3), which are perpendicular to the corresponding planned lines, shifted alternating to one or other side of the planned lines with a random shifting amplitude selected randomly using a distribution function described by a mean value equal to the elongation per segment and a standard deviation of 0.6 mm. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 9a does not belong to the pattern of the electrically conductive element obtained by the method according to the present invention. It should only determine the part of the electrically conductive element obtained by the method according to the present invention shown in Fig. 9a which is shown with more details and a greater magnification in Fig. 9b.

Fig. 9b shows a detailed and magnified schematic representation of the part comprised in the circle shown in Fig. 9a of the pattern of an electrically conductive element obtained by the method according to the present invention shown in Fig. 9a. The segments (2), which are in this case parallel to the planned lines, and the linking segments (3), which are in this case perpendicular to the planned lines, can be seen in this detailed and magnified representation.

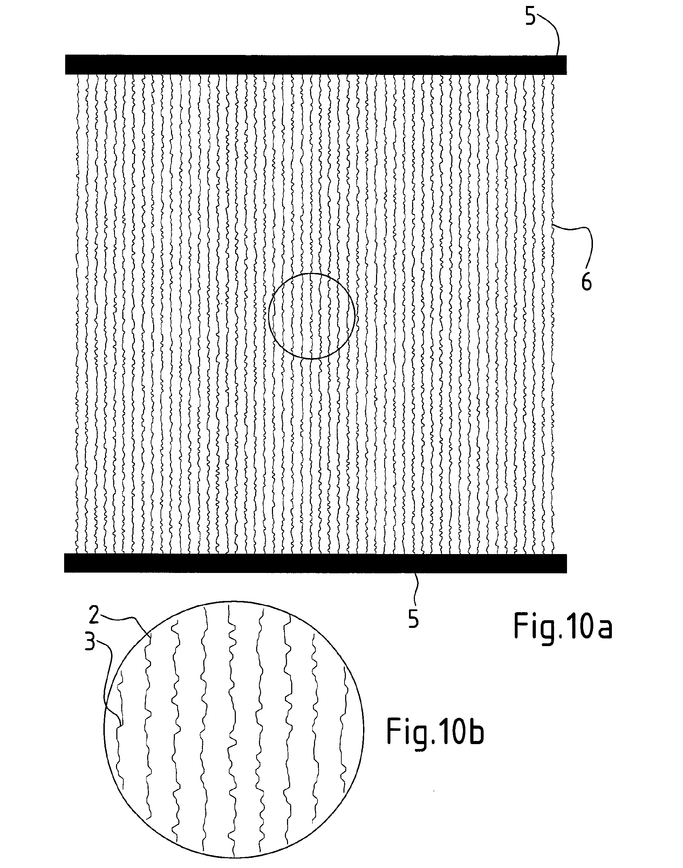

Fig. 10a shows a schematic representation of an example of a pattern of an electrically conductive element comprising lines (6) and two electrical contacts (5) obtained by the method according to the present invention with an elongation of 15% from a planned design of the desired pattern with fifty-two 100 mm long straight planned lines, a spacing of 1.93 mm between the starting and the ending points of the planned lines and 200 straight segments (2) with a length of 0.25 mm per line (6), linked by straight linking segments (3) placed so that they define randomly varying angles with the corresponding planned lines randomly shifted to one or other side of the planned lines with a shifting amplitude selected randomly using a distribution function described by a mean value equal to the elongation per segment and a standard deviation of 0.2 mm. The segments are arranged centred to the bordering segments and/or other elements in a direction, which may preferably be perpendicular to the direction of the lateral shift to one or to the other side of a planned line, so that the angle defined by a linking segments with planned line(s) varies depending on the randomly selected shifting amplitude(s) of the segments linked by the linking segment. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 10a does not belong to the pattern of the electrically conductive element obtained by the method according to the present invention. It should only determine the part of the electrically conductive element obtained by the method according to the present invention shown in Fig. 10a which is shown with more details and a greater magnification in Fig. 10b.

Fig. 10b shows a detailed and magnified schematic representation of the part comprised in the circle shown in Fig. 10a of the pattern of an electrically conductive element obtained by the method according to the present invention shown in Fig. 10a. The segments (2) ), which are in this case parallel to the planned lines, and the linking segments (3), defining varying angles with the planned lines, can be seen in this detailed and magnified representation.

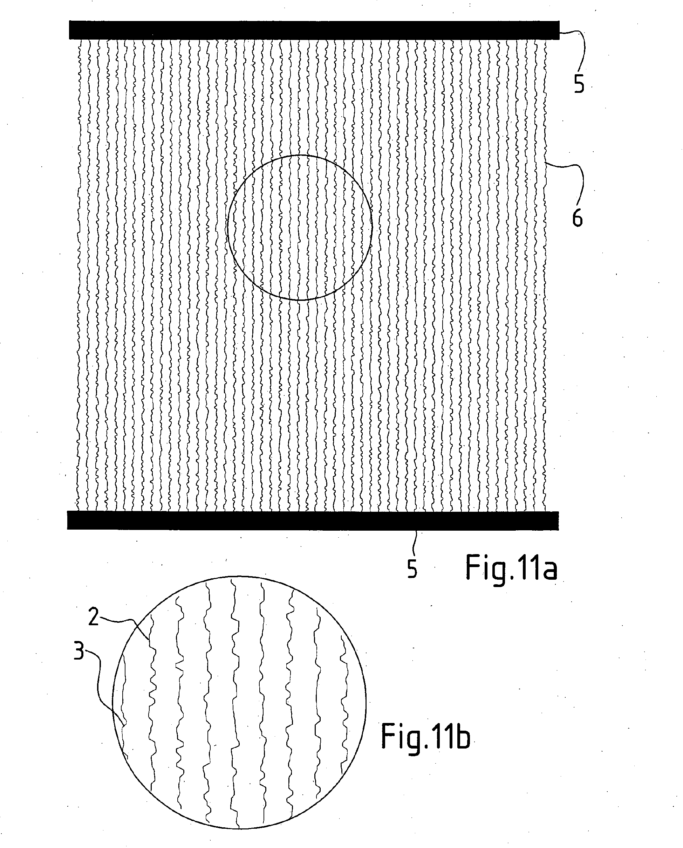

Fig. 11 shows a schematic representation of the pattern of an electrically conductive element comprising lines (6) and two electrical contacts (5) obtained by the method according to the present invention with an elongation of 15%, from a planned design of the desired pattern with fifty-two 100 mm long straight planned lines a spacing of 1.93 mm between the starting and the ending points of the planned lines and 200 straight segments (2) with a length of 0.25 mm per line (6), linked by straight linking segments (3) placed so that they define randomly varying angles between 0° and 90° with the corresponding planned lines, randomly shifted to one or other side of the planned lines with a shifting amplitude selected randomly using a distribution function described by a mean value equal to the elongation per segment and a standard deviation of 0.2 mm. The segments are not only shifted laterally to one or to the other side of a planned line in this case but also in the same plane and in a direction which is perpendicular to the lateral shift to one or to the other side of a planned line, so that the segments are additionally shifted randomly with a shifting amplitude between 0 mm and 0.05 mm upward or downward from their preferred position, which is centred to the bordering segments and/or other elements in a direction, that is perpendicular to the direction of the lateral shift to one or to the other side of a planned line, in the plane of the lateral shift to one or to the other side of a planned line, so that the angle defined by a linking segments with planned line(s) varies depending on the different randomly selected shifting amplitudes for the lateral shift to one or to the other side of a planned line(s) of the segments linked by the linking segment and for the additional shift of the segments linked by the linking segment in the same plane and in a direction which is perpendicular to the lateral shift to one or to the other side of a planned line. Although the electrically conductive element showed to illustrate this pattern is of relatively small dimensions comprising lines with a length of only 100 mm, it should be understood that this electrically conductive element as well as the pattern may be scaled up, for example to fit to the whole surface of a glazing element and especially a windshield or a rear window. The circle shown in Fig. 11a does not belong to the pattern of the electrically conductive element obtained by the method according to the present invention. It should only determine the part of the electrically conductive element obtained by the method according to the present invention shown in Fig. 11a which is shown with more details and a greater magnification in Fig. 11b.

Fig. 11b shows a detailed and magnified schematic representation of the part comprised in the circle shown in Fig. 11a of the pattern of an electrically conductive element obtained by the method according to the present invention shown in Fig. 11a. The segments (2) ), which are in this case parallel to the planned lines, and the linking segments (3) , defining varying angles with the planned lines, can be seen in this detailed and magnified representation.

## Claims

1. Method for patterning electrically conductive elements,
**characterised in that**,
at least two segments linked by at least one linking segment are arranged either randomly shifted to one or to other side of an average position or shifted alternating to one side or to the other side of an average position with a randomly selected shifting amplitude.

2. Method for patterning electrically conductive elements according to claim 1,
**characterised in that**,
the segments are straight or curved.

3. Method for patterning electrically conductive elements according to one or both of the claims 1 and 2,
**characterised in that**,
the shifting amplitude is selected randomly when the segments are randomly shifted to one or to other side of an everage position.

4. Method for patterning electrically conductive elements according one or more then one of the claims 1 to 3,
**characterised in that**,
the shifting amplitude is selected randomly in a preset range.

5. Method for patterning electrically conductive elements according one or more then one of the claims 1 to 4,
**characterised in that**,
the shifting amplitude is related to the elongation.

6. Method for patterning electrically conductive elements according one or more then one of the claims 1 to 5,
**characterised in that,**
lines may comprise between 2 and 10000000 segments.

7. Method for patterning electrically conductive elements according one or more then one of the claims 1 to 6,
**characterised in that**,
the spacing between the starting points and the ending points of at least a part of the lines and/or planned lines or between the starting point and the ending point of at least a part of the lines and/or planned lines and at least one part of the other elements varies randomly.

8. Method for patterning electrically conductive elements according one or more then one of the claims 1 to 7,
**characterised in that**,
the spacing between the starting points and the ending points of at least a part of the lines and/or planned lines or between the starting point and the ending point of at least a part of the lines and/or planned lines and at least one part of the other elements varies randomly in a preset range.

9. Method for patterning electrically conductive elements according one or more then one of the claims 1 to 8,
**characterised in that**,
the spacing between the starting points and the ending points of at least a part of the lines and/or planned lines or between the starting point and the ending point of at least a part of the lines and or planned lines and at least one part of the other elements is selected randomly in a range with a lower limit higher or equal to the mean shifting amplitude plus 8 times the standard deviation of the shifting amplitude values.

10. Method for patterning electrically conductive elements according one or more then one of the claims 1 to 9,
**characterised in that**,
at least two heating zones are created by using different and/or varying angles defined by a planned line and/or, when a planned line is curved, by a tangent, preferably to the middle of a corresponding planned line or to the middle of a curved portion of a corresponding planned line, and the linking segments, different and/or varying distribution functions for the shifting amplitude, different and/or varying mean values for the shifting amplitude, different and/or varying elongations, different ranges for the shifting amplitude, different numbers of segments in at least two different areas of the electrically conductive element, different and/or varying line widths, (a) different and/or varying thickness(es) of at least one electrically conductive layer, different values for the spacing between the starting points and the ending points of at least a part of the lines and/or planned lines or between the starting point and the ending point of at least a part of the lines and/or planned lines and at least one part of the other elements, (a) different and/or varying material(s) for at least one electrically conductive layer.

11. Electrically conductive elements,
**characterised in that,**
they comprise at least one line comprising at least two segments, which are arranged either randomly shifted to one or to the other side of an average position or shifted alternating to one or to other side of an average position with a randomly selected shifting amplitude, linked by at least one linking segment.

12. Electrically conductive elements according claim 11,
**characterised in that**,
they are produced by a method according to one of the claims 1 to 10.

13. Electrically conductive elements according one or both of the claims 11 and 12,
**characterised in that**,
the segments are straight or curved.

14. Electrically conductive elements according one or more then one of the claims 11 to 13,
**characterised in that**,
the shifting amplitude is selected randomly when the segments are randomly shifted either to one or to other side of an average position.

15. Electrically conductive elements according one or more then one of the claims 11 to 14,
**characterised in that**,
the shifting amplitude is selected randomly in a preset range.

16. Electrically conductive elements according one or more then one of the claims 11 to 15,
**characterised in that**,
the shifting amplitude is related to the elongation.

17. Electrically conductive elements according one or more then one of the claims 11 to 16,
**characterised in that**,
the lines may comprise in between 2 and 10000000 segments.

18. Electrically conductive elements according one or more then one of the claims 11 to 17,
**characterised in that**,
the spacing between the starting points and the ending points of at least a part of the lines and/or planned lines or between the starting point and the ending point of at least a part of the lines and/or planned lines and at least a part of other elements varies randomly.

19. Electrically conductive elements according one or more then one of the claims 11 to 18,
**characterised in that**,
the spacing between the starting points and the ending points of at least a part of the lines and/or planned lines or between the starting point and the ending point of at least a part of the lines and/or planned lines and at least a part of other elements varies randomly in a preset range.

20. Electrically conductive elements according one or more then one of the claims 11 to 19,
**characterised in that**,
the spacing between the starting points and the ending points of at least a part of the lines and/or planned lines or between the starting point and the ending point of at least a part of the lines and/or planned lines and at least a part of other elements is selected randomly in a range with a lower limit higher or equal to the mean shifting amplitude plus 8 times the standard deviation of the shifting amplitude values.

21. Electrically conductive elements according one or more then one of the claims 11 to 20,
**characterised in that**,
they comprise at least two heating zones created by using different and/or varying angles defined by a planned line and/or, when a planned line is curved, by a tangent, preferably to the middle of a corresponding planned line or to the middle of a curved portion of a corresponding planned line and the linking segments, different and/or varying distribution functions for the shifting amplitude, different and/or varying mean values for the shifting amplitude, different and/or varying elongations, different ranges for the shifting amplitude, different numbers of segments in at least two different areas of the electrically conductive element, different and/or varying line widths, (a)different and/or varying thickness(es) of at least one electrically conductive layer, different values for the spacing between the starting points and the ending points of at least a part of the lines and/or planned lines or between the starting point and the ending point of at least a part of the lines and/or planned lines and at least one part of the other elements, (a) different and/or varying material(s) for at least one electrically conductive layer.

22. Electrically conductive elements according one or more then one of the claims 11 to 21,
**characterised in that**,
they comprise at least one plastic support layer fixed to the electrically conductive layer.

23. Electrically conductive elements according one or more then one of the claims 11 to 22,
**characterised in that**,
they are at least partially transparent and/or highly transparent.

24. Electrically conductive elements according one or more then one of the claims 11 to 23,
**characterised in that**,
they comprise at least one electrical contact.

25. Electrically conductive elements according one or more then one of the claims 11 to 24,
**characterised in that**,
they comprise at least two different electrical contacts.

26. Electrically conductive elements according one or more then one of the claims 11 to 25,
**characterised in that**,
the electrical contact(s) is/are obtained by patterning at least one electrically conductive layer.

27. The use of electrically conductive elements according one or more then one of the claims 10 to 26,
**characterised in that**,
they are used as antennas and/or or as heating elements on glazing or within laminated glazing.
